# EUROPEAN PATENT SPECIFICATION

(11) **EP 4 015 560 B1**
(45) Date of publication and mention of the grant of the patent: **19.03.2025**
(21) Application number: 21206698.9
(22) Date of filing: 05.11.2021
(51) Int. Cl.: C08G 61/12, C08L 65/00, C09D 165/00, C09K 11/00, H01B 1/00, H01B 5/00, H01M 4/00

(54) **METHOD OF SYNTHESIZING CONDUCTIVE POLYMER AND METHOD OF FABRICATING CONDUCTIVE POLYMER THIN FILM**
VERFAHREN ZUR SYNTHESE EINES LEITFÄHIGEN POLYMERS UND VERFAHREN ZUR HERSTELLUNG EINER LEITENDEN POLYMERDÜNNSCHICHT
PROCÉDÉ DE SYNTHÈSE DE POLYMÈRE CONDUCTEUR ET PROCÉDÉ DE FABRICATION D'UN FILM MINCE POLYMÈRE CONDUCTEUR

(30) Priority: 13.11.2020 KR 20200152166
(43) Date of publication of application: 22.06.2022
(73) Proprietor: Pukyong National University Industry - University Cooperation Foundation, Busan 48547 (KR)
(72) Inventor: KIM, Yong Hyun, 104-503 BUSAN (KR); HAN, Joo Won, 401 ULSAN (KR)
(74) Representative: EP&C

(56) References cited:
- CN-A- 106 810 823
- KR-A- 20200 074 769
- KR-B1- 102 125 401
- US-A1- 2017 241 025

## Description

### BACKGROUND OF THE INVENTION

### Field of the Invention

The present disclosure relates to a method of synthesizing a conductive polymer and a method of fabricating a conductive polymer thin film.

### Description of the Related Art

High-performance transparent conductive electrodes (TCE) are essential for the development of stretchable and flexible optoelectronics technologies that can be integrated into organic light emitting diodes (OLEDs) with low power consumption, fast response speed, and wide viewing angle, organic solar cells with cost-effectiveness, flexibility, low weight, translucency, and suitability for roll-to-roll mass production, or new form factor devices such as textiles, skin-based devices, and wearable devices.

Meanwhile, due to its high light transmittance and high electrical conductivity, indium tin oxide (ITO) as a conventional transparent conductive electrode material is the most commonly used TCE in optoelectronic devices such as organic light emitting diodes and various solar cells. However, its high cost and inherent brittleness, and the need for high-temperature processing severely limit the applicability of ITO to flexible and stretchable electronics.

Therefore, graphene, carbon nanotubes, conductive polymers, metal grids, and metal nanowires have been widely investigated as alternative TCEs to replace ITO. However, these alternative TCEs still have several drawbacks including high cost, low electrical conductivity, non-uniformity on large-area substrates, difficulty in mass production, high electrical resistance to stretchable substrates limiting their application in wearable electronic devices, and poor flexibility and stretchability.

Poly(3,4-ethylenedioxythiophene):poly(styrenesulfonic acid) (PEDOT:PSS) is a promising alternative electrode to replace a conventional ITO electrode due to its excellent electrical and optical properties as well as excellent mechanical flexibility. The efficiency of PEDOT:PSS-based organic solar cells and OLEDs is already approaching that of ITO-based devices. PEDOT:PSS have attracted attention as a transparent flexible electrode for various devices such as organic transistors, organic solar cells, displays, touch sensors, and OLEDs due to its high electrical conductivity, transparency, facile solution processing, and excellent thermal and atmospheric stability. In addition, PEDOT:PSS has an excellent electromagnetic wave shielding function due to its high electrical conductivity properties. Meanwhile, PEDOT:PSS conductive polymer with low electrical conductivity can find application as an antistatic film.

However, the current market for PEDOT:PSS conductive polymer solution with high electrical conductivity is dominated almost exclusively by Heraeus in Germany.

For the synthesis of PEDOT:PSS, poly(styrene sulfonic acid) (PSS) as a polyanion is mainly used as a charge compensator to compensate for the positive charge of PEDOT as a polycation. Dissolved oxygen generated during the synthesis of PEDOT:PSS significantly deteriorates the physical properties of PEDOT:PSS. Such dissolved oxygen, which causes the deterioration in the physical properties of PEDOT:PSS, is generated in the process of dispersing PSS in water, and furthermore, is also generated in the process of polymerizing EDOT, a monomer of PEDOT, in the presence of an oxidizing agent, such as PSS, sodium persulfate (Na₂S₂O₈), and iron sulfate (Fe₂(SO₄)₃), and an H₂O solvent.

KR20200074769A has disclosed a conductive polymer (PEDOT:PSS) coated graphene Ag nanowire nanocomposite electrode and a method of manufacturing thereof.

CN106810823A has disclosed a composition comprising PEDOT:PSS and carbon nanotubes and preparation method thereof.

KR102125401B1 has disclosed the preparation of a composition comprising PEDOT:PSS and carbon nanomaterials, wherein the nanomaterials and PSS are dispersed together, followed by the addition of ethylenedioxythiophene that polymerizes.

US2017/241025A1 has disclosed PEDOT compositions comprising nanomaterials, which may be metal. PEDOT:PSS can be used to prepare nanomaterial containing composites. Halogenated ethylenedioxythiophene or EDOT derivative is polymerized in the presence of a nanomaterial, which may be a metal nanomaterial.

The foregoing is intended merely to aid in the understanding of the background of the present disclosure, and is not intended to mean that the present disclosure falls within the purview of the related art that is already known to those skilled in the art.

### SUMMARY OF THE INVENTION

Accordingly, the present disclosure has been made keeping in mind the above problems occurring in the related art, and an objective of the present disclosure is to provide a novel method of synthesizing a conductive polymer with significantly improved electrical properties and optical absorbance in a ultraviolet region compared to the related art, a method of fabricating a conductive polymer thin film, and a functional film and an electronic device each including the conductive polymer thin film fabricated thereby.

In order to achieve the above objective, according to one aspect of the present disclosure, there is provided a method of synthesizing a conductive polymer, the method including the steps of: (a) preparing a PSS dispersion containing poly (styrene sulfonic acid) (PSS); and (b) preparing a conductive polymer containing poly(3,4-ethylenedioxythiophene):poly(styrenesulfonic acid) (PEDOT:PSS) by allowing a reaction of a mixture containing the PSS dispersion, a 3,4-ethylenedioxythiophene (EDOT) monomer, and an oxidizing agent, wherein the PSS dispersion of step (a) and the mixture of step (b) further comprises a metal nanomaterial consisting of silver (Ag) and a metal nanomaterial precursor consisting of silver nitrate (AgNO₃).

Furthermore, the metal nanomaterial may be in the form of a nanoparticle, a nanowire, a nanorod, or a nanosheet.

Furthermore, the oxidizing agent may be one selected from the group consisting of iron oxide, ammonium persulfate ((NH₄)₂S₂O₈), potassium persulfate (K₂S₂O₈), sodium persulfate (Na₂S₂O₈), potassium peroxodisulfate (K₂O₈S₂), ferric chloride (FeCl₃), ferric bromide (FeBr₃), cupric chloride (CuCl₂), cupric bromide (CuBr₂), potassium ferricyanide (K₃Fe(CN)₆), ferric sulfate (Fe₂(SO₄)₃), ferric perchlorate (Fe(ClO₄)₃), ferric nitrate (Fe(NO₃)₃), molybdenum pentachloride (MoCl₅), ruthenium trichloride (RuCl₃), hydrogen peroxide (H₂O₂), sulfuric acid (H₂SO₄), ferric tosylate (Fe(OTs)₃), and a combination thereof.

The conductive polymer containing PEDOT:PSS synthesized according to the method may be used to fabricate a conductive polymer thin film. To this end, according to another aspect of the present disclosure, there is provided a method of fabricating a conductive polymer thin film, the method including the steps of: (a) preparing a PSS dispersion containing poly(styrene sulfonic acid) (PSS); (b) preparing a conductive polymer containing poly(3,4-ethylenedioxythiophene):poly(styrenesulfonic acid) (PEDOT:PSS) by allowing a reaction of a mixture containing the PSS dispersion, a 3,4-ethylenedioxythiophene (EDOT) monomer, and an oxidizing agent; and (c) forming a coating layer on a substrate using a coating solution containing the conductive polymer, wherein the PSS dispersion of step (a) and the mixture of step (b) further comprises a metal nanomaterial consisting of silver (Ag) and a metal nanomaterial precursor consisting of silver nitrate (AgNO₃).

Furthermore, the coating solution may include at least one selected from the group consisting of a metal nanomaterial, a carbon-based nanomaterial, and an organic-inorganic hybrid nanomaterial.

According to the present disclosure, by introducing the metal nanomaterial or the metal nanomaterial precursor in the form of a nanoparticle or a nanowire to the step of synthesizing the conductive polymer, the PEDOT:PSS, it is possible to synthesize the PEDOT:PSS having significantly improved electrical conductivity compared to PEDOT:PSS prepared by a conventional synthesis method according to the related art.

Specifically, the introduction of the metal nanomaterial to the step of synthesizing the PEDOT:PSS causes a reduction in amount of dissolved oxygen generated during the reaction to prevent oxidation of the EDOT monomer, thereby preventing a deterioration in the electrical conductivity of the finally obtained conductive polymer, the metal nanomaterial itself further improves the conductivity of the PEDOT, and ethanol used as a dispersion medium during the introduction of the metal nanomaterial causes a structural change of the PEDOT:PSS. With this comprehensive effect, it is possible to synthesize the PEDOT:PSS, which has significantly improved electrical conductivity compared to the PEDOT:PSS prepared by the conventional synthesis method according to the related art.

Moreover, the metal nanomaterial also imparts to the conductive polymer an additional function of absorbing light in the ultraviolet region.

Therefore, the PEDOT:PSS with significantly improved electrical conductivity synthesized according to the present disclosure can be used as a transparent electrode replacing an existing ITO, and also can be applied to an electromagnetic wave shielding film, an antistatic film, a hole transport layer for an organic/perovskite device, flexible/stretch conductive wiring of an electronic device. In addition, due to the excellent UV blocking effect thereof the PEDOT:PSS, it is possible to prevent a deterioration in lifespan of an organic activation layer of an organic optoelectronic device such as an organic solar cell, an organic light emitting diode, and an organic optical sensor.

Furthermore, the method of synthesizing PEDOT:PSS the according to the present disclosure is suitable for actual mass production, and thus can greatly contribute to the production of high-performance ITO replacement transparent electrodes, electromagnetic shielding films, and antistatic films, and is highly expected to be applied to related industries and mass-produced in the future

### BRIEF DESCRIPTION OF THE DRAWINGS

The above and other objectives, features, and other advantages of the present disclosure will be more clearly understood from the following detailed description when taken in conjunction with the accompanying drawings, in which:
FIG. 1 is a graph illustrating a comparison experimental result of electrical conductivity of a PEDOT:PSS thin film (w/ Ag NP) fabricated in the present Example and a PEDOT:PSS thin film (Reference) fabricated by a conventional method;
FIG. 2 is a graph illustrating a comparison experimental result of electromagnetic wave shielding properties of the PEDOT:PSS thin film (w/ Ag NP) fabricated in the present Example and the PEDOT:PSS thin film (Reference) fabricated by the conventional method; and
FIG. 3 is a graph illustrating a measurement result of light absorbance of the PEDOT:PSS thin film (w/ Ag NP) fabricated in the present Example.

### DETAILED DESCRIPTION OF THE INVENTION

In the following description of the present disclosure, detailed descriptions of known functions and components incorporated herein will be omitted when it may make the subject matter of the present disclosure unclear.

The terminology used herein is for the purpose of describing particular embodiments only and is not intended to be limiting of the present disclosure. As used herein, the singular forms are intended to include the plural forms as well, unless the context clearly indicates otherwise. It will be further understood that the terms "comprise", "include", "have", etc. when used in this specification, specify the presence of stated features, integers, steps, operations, elements, components, and/or combinations of them but do not preclude the presence or addition of one or more other features, integers, steps, operations, elements, components, and/or combinations thereof.

Hereinafter, the present disclosure will be described in more detail with reference to exemplary embodiments.

However, it should be understood that the embodiments can be variously modified in many different forms and the scope and spirit of the disclosure are not limited to the embodiments described hereinbelow. The embodiments of the present disclosure described hereinbelow is provided for allowing those skilled in the art to more clearly comprehend the present disclosure.

In the present disclosure, poly(3,4-ethylenedioxythiophene) (PEDOT) is prepared using an aqueous solution, non-aqueous solution, or dispersion in the presence of PSS, which is a polyanion. In an effort to solve the problems of a conventional poly(3,4-ethylenedioxythiophene):poly(styrenesulfonic acid) (PEDOT:PSS) synthesis method, the present disclosure is characterized by the use of metal nanomaterials and metal nanomaterial precursors introduced to the step of synthesizing PEDOT:PSS.

Specifically, the present disclosure provides a method of synthesizing a conductive polymer. The method includes the steps of: (a) preparing a PSS dispersion containing poly (styrene sulfonic acid) (PSS); and (b) preparing a conductive polymer containing poly(3,4-ethylenedioxythiophene):poly(styrenesulfonic acid) (PEDOT:PSS) by allowing a reaction of a mixture containing the PSS dispersion, a 3,4-ethylenedioxythiophene (EDOT) monomer, and an oxidizing agent. Here, the PSS dispersion of step (a) and the mixture containing the PSS, the EDOT monomer, and the oxidizing agent of step (b) further contain a metal nanomaterial and a metal nanomaterial precursor.

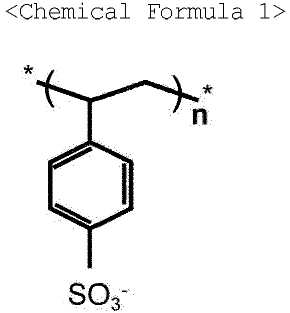

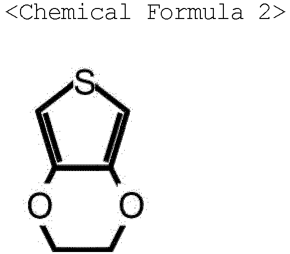

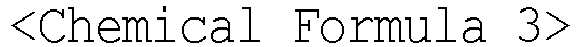

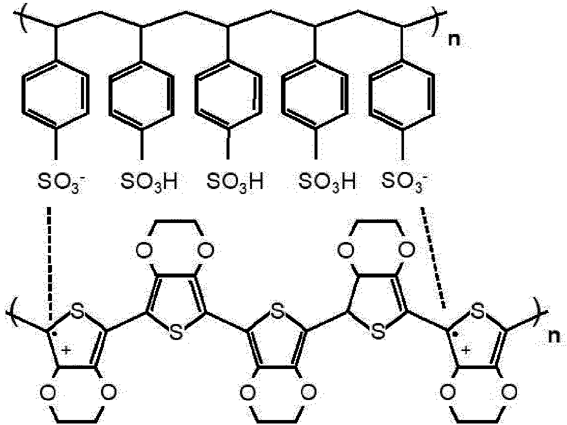

Dissolved oxygen generated during the synthesis of the PEDOT:PSS reacts with the introduced metal nanomaterial to form a metal oxide, with the result that the amount of the dissolved oxygen is reduced. The reduction in the amount of the dissolved oxygen prevents oxidation of the EDOT monomer, the metal nanomaterial further improves conductivity of the PEDOT, and ethanol in which the metal nanomaterial is dispersed causes a structural change of the PEDOT:PSS. With this comprehensive effect, it is possible to realize improved electrical conductivity, which is advantageous over the conventional PEDOT:PSS synthesis method.

Furthermore, for the synthesis of the PEDOT, in step (b), a metal nanomaterial and a metal nanomaterial precursor are included in the mixture containing the PSS, the EDOT monomer, and the oxidizing agent. This further reduces the amount of the dissolved oxygen that oxidizes the EDOT, thereby realizing a further improvement in electrical and optical properties of the PEDOT:PSS.

Meanwhile, the metal nanomaterial introduced in step (a) and step (b) during the synthesis of the conductive polymer is Ag and may be in the form of, but is not limited to, a nanoparticle, a nanowire, a nanorod, or a nanosheet.

In addition, the metal nanomaterial precursor is a nitrate-based precursor, the precursor containing Agi.

In addition, the oxidizing agent included in the mixture for polymerizing the EDOT in step (b) may be one selected from the group consisting of iron oxide, ammonium persulfate ((NH₄)₂S₂O₈), potassium persulfate (K₂S₂O₈), sodium persulfate (Na₂S₂O₃), potassium peroxodisulfate (K₂O₈S₂), ferric chloride (FeCl₃), ferric bromide (FeBr₃), cupric chloride (CuCl₂), cupric bromide (CuBr₂), potassium ferricyanide (K₃Fe(CN)₆), ferric sulfate (Fe₂(SO₄)₃), ferric perchlorate (Fe(ClO₄)₃), ferric nitrate (Fe(NO₃)₃), molybdenum pentachloride (MoCl₅), ruthenium trichloride (RuCl₃), hydrogen peroxide (H₂O₂), sulfuric acid (H₂SO₄), ferric tosylate (Fe(OTs)₃), and a combination thereof.

On the other hand, the conductive polymer containing the PEDOT:PSS synthesized according to the present disclosure may be used to fabricate a conductive polymer thin film. To this end, the present disclosure provides a method of fabricating a conductive polymer thin film. The method includes the steps of: (a) preparing a PSS dispersion containing poly (styrene sulfonic acid) (PSS); (b) preparing a conductive polymer containing poly(3,4-ethylenedioxythiophene):poly(styrenesulfonic acid) (PEDOT:PSS) by allowing a reaction of a mixture containing the PSS dispersion, a 3,4-ethylenedioxythiophene (EDOT) monomer, and an oxidizing agent; and (c) forming a coating layer on a substrate using a coating solution containing the conductive polymer.

The coating solution containing the conductive polymer may be applied on a surface of the substrate to form a conductive polymer thin film on the substrate.

The coating solution used for the fabrication of the conductive polymer thin film may further contain at least one selected from the group consisting of a metal nanomaterial, a carbon-based nanomaterial, and an organic-inorganic hybrid nanomaterial in addition to the conductive polymer containing the PEDOT:PSS.

In this case, the metal nanomaterial is Ag, and may be in the form of, but is not limited to, a nanoparticle, a nanowire, a nanorod, or a nanosheet.

In addition, the carbon-based nanomaterial may be at least one selected from the group consisting of graphene, a carbon nanotube, a carbon nanoparticle, a carbon nanofiber, mesoporous carbon, a carbon nanosheet, a carbon nanorod, and a carbon nanobelt.

In addition, the organic-inorganic nanohybrid material is a nanocomposite material that significantly overcomes the drawbacks of inorganic materials (high brittleness and low-temperature annealing not possible) and organic polymers (low heat resistance and mechanical properties, etc.) by chemically bonding nanoscale inorganic material and organic resin (prepolymer) at the molecular level. For example, an organic-inorganic hybrid material having a structure in which a high amount of ceramic sol is dispersed and dissolved in resin has sufficient formability to be shaped at a relatively low temperature through heat curing and UV crosslinking, and ensures easy chemical crosslinking between organic and inorganic materials. Therefore, compared to a general polymer material, the organic-inorganic hybrid material exhibits excellent physical properties such as thermal properties (high temperature durability, high thermal conductivity), mechanical properties (abrasion resistance, scratch resistance, high adhesion, high hardness), and optical properties (transparency, discoloration resistance, high refraction).

Furthermore, the coating solution may further contain a conductivity-increasing additive in order to increase electrical conductivity of the conductive polymer thin film.

Examples of the conductivity-increasing additive include, but are not limited to, sulfuric acid or a sulfuric acid derivative compound containing -SO₃- or -SO₃H.

The sulfuric acid or sulfuric acid derivative compound may be selected from the group consisting of methanesulfonic acid, trifluoromethansulfonic acid, sulfuric acid, perchloric acid, benzenesulfonic acid, p-toluenesulfonic acid, 4-ethylbenzenesulfonic acid, 4-sulfophthalic acid, p-xylene-2-sulfonic acid hydrate, 5-amino-1-naphthalenesulfonic acid, 8-amino-2-naphthalenesulfonic acid, 4-amino-2-naphthalenesulfonic acid, taurine, 1,4-butanedisulfonic acid, sulfurous acid, bis(trifluoromethane)sulfonamide, and a mixture of at least two thereof, but is not limited thereto.

Examples of the conductivity-increasing additive other than the sulfuric acid or sulfuric acid derivative compound may include: an ether-group-containing compound such as tetrahydrofuran; a lactone-group-containing compound such as γ - butyrolactone and γ -valerolactone; an amide- or lactam-group-containing compound such as caprolactam, N-methylcaprolactam, N,N-dimethylacetamide, N-methylacetamide, N,N-dimethylformamide (DMF), N-methylformamide, N-methylformanilide, N-methylpyrrolidone (NMP), N-octylpyrrolidone, and pyrrolidone; sulfone and sulfoxide such as sulfonate (tetramethylenesulfone) and dimethylsulfoxide (DMSO); a sugar or sugar derivative such as glucose, fructose, and lactose; sugar alcohol such as sorbitol and mannitol; a furan derivative such as 2-furan carboxylic acid, 3-furan carboxylic acid; and/or di- or polyalcohol such as ethylene glycol, glycerin, di- or triethylene glycol. In particular, the conductivity-increasing additive may be selected from the group consisting of tetrahydrofuran, N-methylformamide, N-methylpyrrolidone, ethylene glycol, dimethylsulfoxide or sorbitol, and a mixture of at least two thereof, but is not limited thereto.

Meanwhile, the substrate on which the coating layer is formed using the coating solution containing the conductive polymer is not particularly limited in type. For example, a substrate used in a conventional semiconductor process may be used as the substrate for the conductive polymer thin film according to the present application.

For example, the substrate may be at least one selected from the group consisting of a glass substrate, a plastic substrate, a silicon substrate, a silicon oxide substrate, a Teflon film substrate, a sapphire substrate, a nitride substrate, a metal foil (e.g., a copper foil or an aluminum foil), a steel substrate (e.g., stainless steel, etc.), a polydimethylsiloxane (PDMS) substrate, a chitosan substrate, and a polymer substrate. In this case, the plastic substrate is made of a material selected from the group consisting of polyethersulfone (PES), polyethylene naphthalate (PEN), polyethylene terephthalate (PET), polycarbonate (PC), polystyrene (PS), polyimide (PI), polyethylene (PE), and a combination thereof.

In one example, in the step of forming the conductive polymer coating layer (PEDOT:PSS thin film) on the surface of the substrate, the conductive polymer coating layer may be formed using known techniques such as spin-coating, casting, a Langmuir-Blodgett (LB) method, ink-jet printing, nozzle printing, slot-die coating, doctor blade coating, screen printing, dip coating, gravure printing, reverse-offset printing, a physical transfer method, spray coating, chemical vapor deposition, and thermal evaporation.

If necessary, the method of fabricating the conductive polymer thin film according to the present disclosure may further include, after the forming of the conductive polymer coating layer on the substrate, a post-treatment step of immersing the substrate on which the coating layer is formed in a solution containing a conductivity-increasing additive, or applying the solution containing the conductivity-increasing additive on the coating layer.

Examples of the conductivity-increasing additive used in the post-treatment step include, but are not limited to, sulfuric acid or a sulfuric acid derivative compound containing -SO₃- or -SO₃H.

The sulfuric acid or sulfuric acid derivative compound may be selected from the group consisting of methanesulfonic acid, trifluoromethansulfonic acid, sulfuric acid, perchloric acid, benzenesulfonic acid, p-toluenesulfonic acid, 4-ethylbenzenesulfonic acid, 4-sulfophthalic acid, p-xylene-2-sulfonic acid hydrate, 5-amino-1-naphthalenesulfonic acid, 8-amino-2-naphthalenesulfonic acid, 4-amino-2-naphthalenesulfonic acid, taurine, 1,4-butanedisulfonic acid, sulfurous acid, bis(trifluoromethane)sulfonamide, and a mixture of at least two thereof, but is not limited thereto.

Examples of the conductivity-increasing additive other than the sulfuric acid or sulfuric acid derivative compound may include: an ether-group-containing compound such as tetrahydrofuran; a lactone-group-containing compound such as γ - butyrolactone and γ -valerolactone; an amide- or lactam-group-containing compound such as caprolactam, N-methylcaprolactam, N,N-dimethylacetamide, N-methylacetamide, N,N-dimethylformamide (DMF), N-methylformamide, N-methylformanilide, N-methylpyrrolidone (NMP), N-octylpyrrolidone, and pyrrolidone; sulfone and sulfoxide such as sulfonate (tetramethylenesulfone) and dimethylsulfoxide (DMSO); a sugar or sugar derivative such as glucose, fructose, and lactose; sugar alcohol such as sorbitol and mannitol; a furan derivative such as 2-furan carboxylic acid, 3-furan carboxylic acid; and/or di- or polyalcohol such as ethylene glycol, glycerin, di- or triethylene glycol. In particular, the conductivity-increasing additive may be selected from the group consisting of tetrahydrofuran, N-methylformamide, N-methylpyrrolidone, ethylene glycol, dimethylsulfoxide or sorbitol, and a mixture of at least two thereof, but is not limited thereto.

The conductive polymer thin film fabricated by the method according to the present disclosure can be used as a core component of various functional films or electronic devices.

For example, the conductive polymer thin film according to the present disclosure may be used as a material for various electronic devices such as transparent electrodes included in organic solar cells, organic light emitting diodes, image sensors, transparent electrodes included in photodetectors and optical sensors, flexible/stretchable conductive wiring for stretchable wearable devices, and hole transport layers for organic/perovskite devices, and may also be used as a material for functional films such as electromagnetic wave shielding films and antistatic films.

Hereinafter, the present disclosure will be described in more detail with reference to Examples.

### <Example>

### 1. PEDOT:PSS solution synthesis method

To disperse PSS in water, 110 g of the PSS was dissolved in 380 g of deionized water (DI water), and 2.7 g of an Ag nanoparticle was added thereto and stirred until transparent to obtain a PSS aqueous dispersion. Since dissolved oxygen that deteriorates the physical properties of PEDOT:PSS is generated in the process of dispersing the PSS in water, a metal monomer such as silver nitrate (AgNO₃) or a metal nanomaterial such as an Ag nanoparticle and an Ag nanowire was introduced to the step of dispersing the PSS in water, so that dissolved oxygen reacted with Ag to form AgOx metal oxide, with the result that the amount of dissolved oxygen was reduced.

An EDOT monomer was heated to a temperature of 40°C at which it evaporates. The resulting EDOT monomer in vapor phase was cooled again to collect the EDOT monomer in liquid phase. Through this purification process, a high purity EDOT monomer was obtained.

In the PSS aqueous dispersion thus prepared above, 1.6 g of a purified EDOT monomer, 2.8 g of a sodium persulfate (Na₂S₂O₃) oxidizing agent, and 0.05 g of a ferric sulfate (Fe₂(SO₄)₃) oxidizing agent were mixed and stirred at a temperature of 15°C for 12 hours. Also, 1.5 g of an Ag nanoparticle was added. When a metal monomer such as silver nitrate (AgNO₃) or a metal nanomaterial such as an Ag nanoparticle or an Ag nanowire was introduced to this step, the amount of dissolved oxygen that oxidizes the EDOT was reduced once again.

In addition, in order to increase electrical conductivity of PEDOT:PSS, 2.8 g of sulfuric acid as a conductivity-increasing additive was added to a PEDOT:PSS solution.

After the above reaction was completed, a final low-dissolved oxygen PEDOT:PSS solution containing Ag nanomaterials was obtained.

### 2. PEDOT:PSS thin film formation method

In order to fabricate a PEDOT:PSS thin film that can be used as a transparent electrode, the PEDOT:PSS solution thus synthesized by the above method was spin-coated on a plasma-treated glass substrate at a rotation speed of 1500 rpm for 30 seconds, followed by annealing at 120°C for 10 minutes.

In order to fabricate a PEDOT:PSS thin film that can be used as an electromagnetic shielding film, the PEDOT:PSS solution thus synthesized by the above method was drop-casted on a plasma-treated PET substrate, followed by annealing in an oven at 120°C for 3 hours.

### 3. Characteristic analysis result of PEDOT:PSS thin film

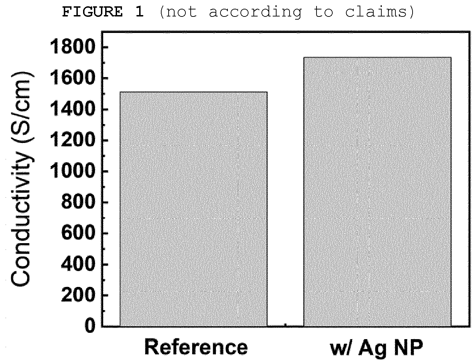

FIG. 1 illustrates electrical conductivity of the PEDOT:PSS thin film that can be used as a transparent electrode. It is observed that the electrical conductivity of the PEDOT:PSS thin film fabricated by introducing the metal nanomaterial through the above method according to the present disclosure is 1735 S/cm, which is an improved value compared to an electrical conductivity of 1512 S/cm of a PEDOT:PSS thin film of Comparative Example in which no metal nanomaterial is introduced.

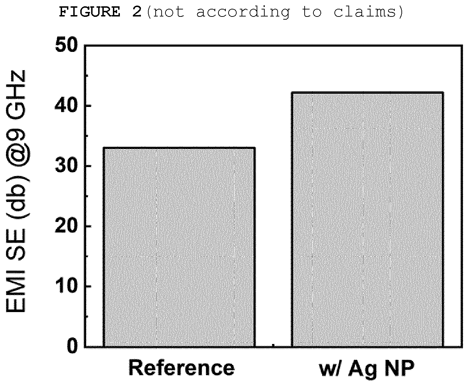

FIG. 2 illustrates electromagnetic wave shielding properties of the PEDOT:PSS thin film that can be used as an electromagnetic wave shielding film. It is observed that an electromagnetic wave shielding rate of the PEDOT:PSS thin film fabricated by introducing the metal nanomaterial through the above method according to the present disclosure is 42.2 dB (@9 GHz), which is an improved value compared to an electromagnetic wave shielding rate of 33.0 dB (@9 GHz), of the PEDOT:PSS thin film of Comparative Example in which no metal nanomaterial of the comparative example is introduced.

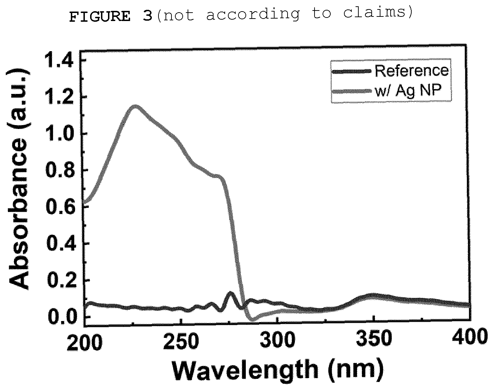

FIG. 3 illustrates light absorbance of the PEDOT:PSS thin film. It is observed that the light absorbance in an ultraviolet region of the PEDOT:PSS thin film fabricated by introducing the metal nanomaterial through the above method according to the present disclosure is greater than that of the PEDOT:PSS thin film of Comparative Example in which no metal nanomaterial is introduced.

## Claims

1. A method of synthesizing a conductive polymer, the method comprising the steps of:
(a) preparing a PSS dispersion comprising poly(styrene sulfonic acid) (PSS); and
(b) preparing a conductive polymer comprising poly(3,4-ethylenedioxythiophene) :poly(styrenesulfonic acid) (PEDOT:PSS) by allowing a reaction of a mixture comprising the PSS dispersion, a 3,4-ethylenedioxythiophene (EDOT) monomer, and an oxidizing agent,
wherein the PSS dispersion of step (a) and the mixture of step (b) further comprises a metal nanomaterial consisting of silver (Ag) and a metal nanomaterial precursor consisting of silver nitrate (AgNO₃).

2. The method of claim 1, wherein the metal nanomaterial is in the form of a nanoparticle, a nanowire, a nanorod, or a nanosheet.

3. The method of claim 1, wherein the oxidizing agent is one selected from the group consisting of iron oxide, ammonium persulfate ((NH₄)₂S₂O₈), potassium persulfate (K₂S₂O₈), sodium persulfate (Na₂S₂O₈), potassium peroxodisulfate (K₂O₈S₂), ferric chloride (FeCl₃), ferric bromide (FeBr₃), cupric chloride (CuCl₂), cupric bromide (CuBr₂), potassium ferricyanide (K₃Fe(CN)₆), ferric sulfate (Fe₂(SO₄)₃), ferric perchlorate (Fe(ClO₄)₃), ferric nitrate (Fe(NO₃)₃), molybdenum pentachloride (MoCl₅), ruthenium trichloride (RuCl₃), hydrogen peroxide (H₂O₂), sulfuric acid (H₂SO₄), ferric tosylate (Fe(OTs)₃), and a combination thereof.

4. A method of fabricating a conductive polymer thin film, the method comprising the steps of:
(a) preparing a PSS dispersion comprising poly(styrene sulfonic acid) (PSS);
(b) preparing a conductive polymer comprising poly(3,4-ethylenedioxythiophene):poly(styrenesulfonic acid) (PEDOT:PSS) by allowing a reaction of a mixture comprising the PSS dispersion, a 3,4-ethylenedioxythiophene (EDOT) monomer, and an oxidizing agent; and
(c) forming a coating layer on a substrate using a coating solution containing the conductive polymer,
wherein the PSS dispersion of step (a) and the mixture of step (b) further comprises a metal nanomaterial consisting of silver (Ag) and a metal nanomaterial precursor consisting of silver nitrate (AgNO₃).

5. The method of claim 4, wherein the coating solution comprises at least one selected from the group consisting of a metal nanomaterial, a carbon-based nanomaterial, and an organic-inorganic hybrid nanomaterial.

## Patentansprüche

1. Verfahren zur Synthese eines leitfähigen Polymers, wobei das Verfahren die Schritte umfasst:
(a) Herstellen einer PSS-Dispersion, die Poly(styrolsulfonsäure) (PSS) umfasst; und
(b) Herstellen eines leitfähigen Polymers, das Poly(3,4-ethylendioxythiophen):Poly(styrolsulfonsäure) (PEDOT:PSS) umfasst, durch Erlauben einer Umsetzung eines Gemischs, das die PSS-Dispersion, ein 3,4-Ethylendioxythiophen(EDOT)-Monomer und ein Oxidationsmittel umfasst,
wobei die PSS-Dispersion von Schritt (a) und das Gemisch von Schritt (b) ferner ein Metall-Nanomaterial, das aus Silber (Ag) besteht, und einen Metall-Nanomaterial-Vorläufer, der aus Silbernitrat (AgNO₃) besteht, umfassen.

2. Verfahren nach Anspruch 1, wobei das Metall-Nanomaterial in der Form eines Nanopartikels, eines Nanodrahts, eines Nanostäbchens oder eines Nanoblatts vorliegt.

3. Verfahren nach Anspruch 1, wobei das Oxidationsmittel eines ausgewählt aus der Gruppe bestehend aus Eisenoxid, Ammoniumpersulfat ((NH₄)₂S₂O₈), Kaliumpersulfat (K₂S₂O₈), Natriumpersulfat (Na₂S₂O₈), Kaliumperoxodisulfat (K₂O₈S₂), Eisen(III)-chlorid (FeCl₃), Eisen(III)-bromid (FeBr₃), Kupfer(II)-chlorid (CuCl₂), Kupfer(II)-bromid (CuBr₂), Kaliumferricyanid (K₃Fe(CN)₆), Eisensulfat (Fe₂(SO₄)₃), Eisenperchlorat (Fe(ClO₄)₃), Eisennitrat (Fe(NO₃)₃), Molybdänpentachlorid (MoCl₅), Rutheniumtrichlorid (RuCl₃), Wasserstoffperoxid (H₂O₂), Schwefelsäure (H₂SO₄), Eisen(III)-tosylat (Fe(OTS)₃) und einer Kombination davon ist.

4. Verfahren zur Herstellung eines leitfähigen Polymerdünnfilms, wobei das Verfahren die Schritte umfasst:
(a) Herstellen einer PSS-Dispersion, die Poly(styrolsulfonsäure) (PSS) umfasst;
(b) Herstellen eines leitfähigen Polymers, das Poly(3,4-ethylendioxythiophen):Poly(styrolsulfonsäure) (PEDOT:PSS) umfasst, durch Erlauben einer Umsetzung eines Gemischs, das die PSS-Dispersion, ein 3,4-Ethylendioxythiophen(EDOT)-Monomer und ein Oxidationsmittel umfasst; und
(c) Bilden einer Beschichtungsschicht auf einem Substrat unter Verwendung einer Beschichtungslösung, die das leitfähige Polymer enthält,
wobei die PSS-Dispersion von Schritt (a) und das Gemisch von Schritt (b) ferner ein Metall-Nanomaterial, das aus Silber (Ag) besteht, und einen Metall-Nanomaterial-Vorläufer, der aus Silbernitrat (AgNO₃) besteht, umfassen.

5. Verfahren nach Anspruch 4, wobei die Beschichtungslösung wenigstens eines ausgewählt aus der Gruppe bestehend aus einem Metall-Nanomaterial, einem Nanomaterial auf Kohlenstoffbasis und einem organischanorganischen Hybrid-Nanomaterial umfasst.

## Revendications

1. Procédé de synthèse d'un polymère conducteur, le procédé comprenant les étapes de :
(a) préparation d'une dispersion de PSS comprenant un poly(acide styrène sulfonique) (PSS) ; et
(b) préparation d'un polymère conducteur comprenant du poly(3,4-éthylènedioxythiophène):poly(acide styrène sulfonique) (PEDOT:PSS) en laissant réagir un mélange comprenant la dispersion de PSS, un monomère de 3,4-éthylènedioxythiophène (EDOT) et un agent oxydant,
dans lequel la dispersion de PSS de l'étape (a) et le mélange de l'étape (b) comprennent en outre un nanomatériau métallique constitué d'argent (Ag) et un précurseur de nanomatériau métallique constitué de nitrate d'argent (AgNO₃).

2. Procédé selon la revendication 1, dans lequel le nanomatériau métallique est sous la forme d'une nanoparticule, d'un nanofil, d'une nanotige ou d'une nanofeuille.

3. Procédé selon la revendication 1, dans lequel l'agent oxydant est un agent choisi dans le groupe constitué par l'oxyde de fer, le persulfate d'ammonium ((NH₄)₂S₂O₈)le persulfate de potassium (K₂S₂O₈), le persulfate de sodium (Na₂S₂O₈), le peroxodisulfate de potassium (K₂O₈S₂), le chlorure ferrique (FeCl₃), le bromure ferrique (FeBr₃), le chlorure cuivrique (CuCl₂), le bromure cuivrique (CuBr₂), le ferricyanure de potassium (K₃Fe(CN)₆), le sulfate ferrique (Fe₂(SO₄)₃), le perchlorate ferrique (Fe(ClO₄)₃), le nitrate ferrique (Fe(NO₃)₃), le pentachlorure de molybdène (MoCl₅), le trichlorure de ruthénium (RuCl₃), le peroxyde d'hydrogène (H₂O₂), l'acide sulfurique (H₂SO₄), le tosylate ferrique (Fe(OTs)₃), et une combinaison de ceux-ci.

4. Procédé de fabrication d'un film mince de polymère conducteur, le procédé comprenant les étapes de :
(a) préparation d'une dispersion de PSS comprenant un poly(acide styrène sulfonique) (PSS) ;
(b) préparation d'un polymère conducteur comprenant du poly(3,4-éthylènedioxythiophène):poly(acide styrène sulfonique) (PEDOT:PSS) en laissant réagir un mélange comprenant la dispersion de PSS, un monomère de 3,4-éthylènedioxythiophène (EDOT) et un agent oxydant ; et
(c) formation d'une couche de revêtement sur un substrat à l'aide d'une solution de revêtement contenant le polymère conducteur,
dans lequel la dispersion de PSS de l'étape (a) et le mélange de l'étape (b) comprennent en outre un nanomatériau métallique constitué d'argent (Ag) et un précurseur de nanomatériau métallique constitué de nitrate d'argent (AgNO₃).

5. Procédé selon la revendication 4, dans lequel la solution de revêtement comprend au moins l'un choisi dans le groupe constitué par un nanomatériau métallique, un nanomatériau à base de carbone et un nanomatériau hybride organique-inorganique.
